# EUROPEAN PATENT APPLICATION

(11) **EP 2 428 979 A1**
(43) Date of publication of application: **14.03.2012**
(21) Application number: 10772024.5
(22) Date of filing: 05.05.2010
(51) Int. Cl.: H01L 21/00, H01L 33/00

(54) **SOLID-STATE LASER LIFT-OFF APPARATUS AND LIFT-OFF METHOD**

(30) Priority: 08.05.2009 CN 200910136457
(71) Applicant: Sino Nitride Semiconductor Co, Ltd, Guangdong 523500 (CN)
(72) Inventor: ZHANG, Guoyi, Guangdong 523500 (CN); YANG, Xinrong, Guangdong 523500 (CN); HE, Mingkun, Guangdong 523500 (CN); SUN, Yongjian, Guangdong 523500 (CN)
(74) Representative: Bohnenberger, Johannes
(86) International application number: PCT/CN2010/072466
(87) International publication number: WO 2010/127621

(57) **Abstract**

A solid-state laser lift-off apparatus comprises: a solid-state laser (1), a light beam shaping lens (3), motors of oscillating mirrors (5,7), oscillating mirrors (4,6), a field lens (9), a movable platform (10), an industrial control computer and control software (8). The light beam shaping lens (3) is behind the solid-state laser (1), shaping the laser beam from the solid-state laser (1) into required shape. The motors of oscillating mirrors (5,7) are in front of the field lens (9), controlling the movement of the oscillating mirrors (4,6) according to the instruction of the control software (8) to implement different light beam scanning paths. A lift-off method for applying the solid-state laser lift-off apparatus uses a small laser spot to perform scanning, and enables damage-free separation of GaN from a sapphire substrate.

## Description

### TECHNICAL FIELD

The present invention relates to the technical field of the semiconductor manufacturing, especially a kind of semiconductor film lift-off apparatus and lift-off method for applying solid-state laser to separate film materials. The present invention enables the laser beam to be shaped into specific shapes and specific distributions of optical fields through special light paths, and decomposes the interface materials by focusing the laser on the interfaces between the multiple layers, so as to achieve the function of separating film layer from the substrate.

### BACKGROUND OF THE INVENTION

In recent years, III/V nitride materials, mainly GaN, InGaN, and AlGaN, have received much attention as semiconductor materials. Due to their continuous and variable direct band gap from 1.9 to 6.2 eV, excellent physical and chemical stability, and high saturation electron mobility, the III/V nitride materials are the most preferred materials for optoelectronic devices such as laser devices and light-emitting diodes.

Due to the limitation in the growth technologies of GaN, however, large area of GaN materials are mostly grown on sapphire substrates. Although the GaN grown on a sapphire substrate has high quality and wide applications, the develpoment of GaN based semiconductor devices is largely limited by the non electro-conductivity and poor thermal-conductivity of the sapphires. In order to avoid such disadvantages, methods have been invented to replace the sapphires substrate after the growth of GaN based devices on sapphires. The GaN film can be transferred to a better heatsink bonding or be used as a kind of homoepitaxial substrate after lifting off the substrate. A commonly applied method for the removal of sapphire is laser lift-off technology.

The laser lift-off technology (Lift-off) was first implemented by HP company of US on AlGainP/GaAs LED because the GaAs substrate leads to a very high light absorption loss inside the LED. The light-emitting efficiency can be improved nearly 2 times higher by separating the GaAs substrate and then adhered to the transparent Gap substrate. Based on a kind of GaN heteroepitaxial development technology, M.K.Kelly et al. of US advanced the laser lift-off (LLO) technology of GaN based materials in 1996 using the third-harmonic frequency laser of YAG to separate the thick GaN film which grows on the sapphire substrate through HVPE technology. In 1998, W.S.Wong et al. made GaN based LED and laser diodes by using LLO technology. The laser lift-off techniques receives extensive attention .

The laser lift-off technology resolves the serial problems such as heat emission, current crowding and low light-emitting efficiency which exist in the GaN based LED on sapphire substrate. It is the most prospective technology to remove the above mentioned lighting obstacles. Firstly, after transferred to the heatsink having high thermal-conductivity, the epitaxial wafer largely improves the heat-emitting efficiency and reduces the LED junction temperature. The reduction of LED junction temperature will highly improve the light-emitting efficiency and stability of the LED and extend the LED's service life. The lift-off technology can save the technical costs substantively because it decreases the processes such as etching, wafer abrasion, wafer scribing, etc., and the separated substrate can be used repeatly.

The IX-1000 laser lift-off apparatus of US JPSA company is the main commercialized laser lift-off apparatus at the present time. It applies high-power KrF quasi-molecule laser with 248nm wavelengh and 25-38ns pulse width. Through accurate control on the energy and uniformization of the light beam energy distribution, the laser focuses on the GaN buffer layer to decompose the GaN into gallium and nitrogen so as to implement the separation of GaN from the substrate. The YAG third harmonic frequency solid-state laser with Q switch is also applied besides the KrF quasi-molecule laser, mainly by the M.K.Kelly group of US and R.H.Horng group of China Taiwan. The solid-state laser can achieve a rather high pulse energy through Q switch technology. Moreover, it is convenient to be maintained. But there are still no such kind of solution possesses mature commercial devices because of its technical limitation.

The above-mentioned lift-off methods have the characteristics below:
1. applying lift-off techniques chip by chip and implementing separation through large laser spot (the large laser spot is larger than or equivalent to a component (chip)).
2. the size of the laser spot should change according to the size of device units.
3. the laser spot has an uniform energy distribution and shows a flat roof shape.
4. the laser spot has strong energy whose energy density is more than 0.6J/cm² generally.
5. using movable platform and visual recognition system to accomplish the positioning between each device unit and the laser spot.

Although the above two solutions have solved the lift-off problem after industry applications in the last several years, some problems presented themselves in the meantime, mainly comprising the following several aspects:
1.The energy stability of each laser pulse can't be assured because of the feature of KrF laser. The energy likely waves so as to destroy the configurations of the components and reduce the yields.
2. The parameters of the laser lift-off can't be adjusted accurately because the size of the laser spot should be regulated according to the specifications of the components, so the consistency of the lift-off effect can't be assured.
3. In recent years, the industry always questioned such large area lift-off method because of the large laser spot. The GaN decomposes simultaneously in the irradiation area which leads to large stress and deformation in the decomposition area, so as to imperil the quality and the service life of the chip. Although manual adjustment enables the GaN's decomposition as accurate as possible, such macroscopical adjustment is difficult to meet the microcosmic requirement. In the meantime, it makes the laser adjustment more difficult because of the discreteness of the pulse energy of the KrF quasi-molecule laser.

### Content of the invention

The present invention aims to provide a kind of laser lift-off apparatus and lift-off method more reliable, convenient and with low cost. The present invention adopts the micro area laser lift-off (MicroAreaLLO) technology and the high speed blind scanning laser lift-off method without unneccessary accurate positioning, and enables the damage-free separation of GaN from the sapphire substrate.

The present invention provides a kind of solid-state laser lift-off apparatus which is characterized that: comprising a solid-state laser, a light beam shaping lens, motors of oscillating mirrors, oscillating mirrors and a field lens, as well as a movable platform, an industrial control computer and control software; the said light beam shaping lens is under the said solid-state laser; the said oscillating mirrors, motors of oscillating mirrors and the said field lens, light beam shaping lens are behind the said solid-state laser, shaping the laser beam from the solid-state laser; the said motors of oscillating mirrors are in front of the field lens, controlling the movement of the oscillating mirrors according to the instruction of the control software to implement different light beam scanning paths; the said movable platform is under the said solid-state laser; the said control software runs in the said industrial control computer.

In the solid-state laser lift-off apparatus of the present invention, the said laser light beam shaping lens shapes the laser spots into small laser spots in different geometric shapes.

In the solid-state laser lift-off apparatus of the present invention, the said geometric shapes include square, rectangle, round, ellipse, pentagon and hexagon.

In the solid-state laser lift-off apparatus of the present invention, the said small laser spot is a square laser spot with a perimeter of 3∼1000µm.

In the solid-state laser lift-off apparatus of the present invention, the said small laser spot is a round laser spot with a perimeters of 3∼300µm.

In the solid-state laser lift-off apparatus of the present invention, the energy of the said small laser spot is the highest in the center and is gradually reduced toward the periphery.

In the solid-state laser lift-off apparatus of the present invention, the said solid-state laser is a DPSS solid-state laser with a wavelengh less than 400nm.

In the solid-state laser lift-off apparatus of the present invention, the said light scanning is produced by using the motors of oscillating mirrors to drive the oscillating mirrors.

The present invention also provides a kind of method for applying the above-mentioned solid-state laser lift-off apparatus, is characterized by using small laser spot to scan.

In the lift-off method of the present invention, the said small laser spot is a square laser spot with a perimeter of 3∼1000µm.

In the lift-off method of the present invention, the said small laser spot is a round laser spot with a diameter of 3∼300µm.

In the lift-off method of the present invention, the energy of the said small laser spot is the highest in the center and is gradually reduced toward the periphery.

In the lift-off method of the present invention, various different scanning paths are used.

In the lift-off method of the present invention, the said small laser spot scans in any direction for separation and doesn't need to be positioned with the chip accurately during the scanning.

### Deccription of the drawings

The present invention will be illustrated referring to the drawing. Among the figures:
Figure 1 is a schematic diagram of the solid-state laser lift-off apparatus of the present invention;
Figure 2 is a schematic diagram of the light beam shaping of the present invention;
Figure 3a is a energy distribution map of the pulse laser spot of the prior art;
Figure 3b is a energy distribution map of the pulse laser spot of the present invention;
Figure 4 - Figure 8 are the schematic diagrams of the scanning paths;
Figure 9 is a microscopic photograph after a small laser spot damage-free laser lift-off of the present invention.

### SPECIFIC MODE FOR CARRYING OUT THE INVENTION

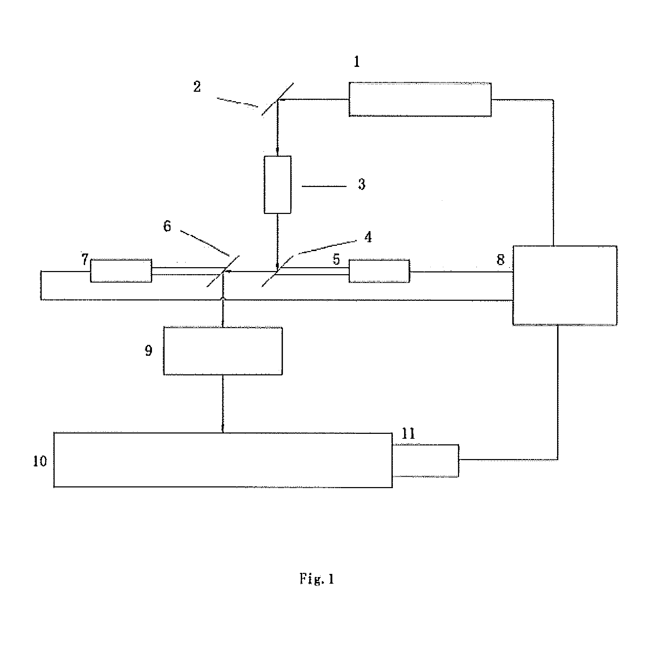

Figure 1 is the schematic diagram of the solid-state laser lift-off apparatus which comprises a solid-state laser, a light beam shaping lens, motors of oscillating mirrors, oscillating mirrors and a field lens, as well as a movable platform, an industrial control computer and control software (not shown in the figure). The present invention uses solid-state laser as the laser source. The light beam shaping lens, the oscillating lens, the motors of oscillating lens and the field mirrors are under the laser. The light beam shaping lens is behind the laser, shaping the laser beam from the laser into required shape of the present invention. The motors of oscillating mirrors are in front of the field lens, controlling the movement of the oscillating mirrors according to the instruction of the control software so as to implement different light beam scanning paths.

According to the present invention, the lift-off apparatus and the lift-off method for separating GaN from a sapphire substrate use solid-state laser as the laser source, and use small laser spot with a perimeter of 3∼ 1000µm, a longest distance between two angles or a largest diameter no more than 400µm, to scan spot by spot, line by line. And the energy distribution condition inside the small laser spot is that the energy is the highest in the center of the small laser spot and is gradually reduced toward the periphery.

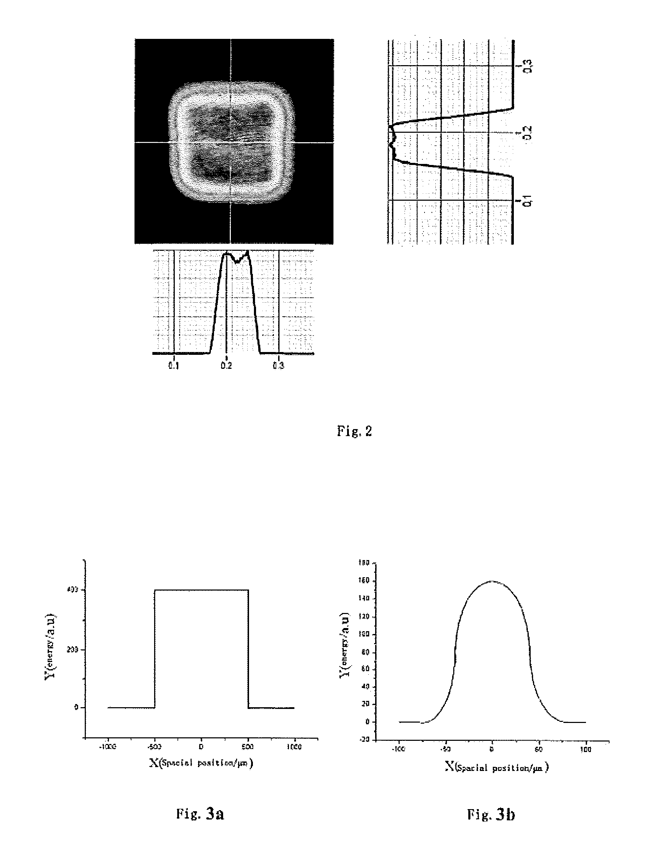

The present invention makes amendments to the large laser spot lift-off technology among the prior laser lift-off technologies, and implements blind scanning without unneccessary accurate positioning by small spot to separate the GaN film or GaN component. There are three important reasons for the small laser spot method not be advanced for a long time: (1)it is generally regarded that the small laser spot lift-off brings the laser spot edge problem into the GaN-based device unit which leads to reduce the quality of the laser lift-off even worse. (2)it is generally regarded that the single pulse energy of the solid-state laser probably can not reach the threshold value of the laser lift-off. (3)there is no report indicating that the small laser spot can implement damage-free laser lift-off. The small laser spot adopted by the present invention has a perimeter of 3 -1000µm, and a longest distance between two angles or a largest diameter no more than 400µm, preferably, a perimeter of 100 - 400pm , and a longest distance between two angles or a largest diameter no more than 150µm. The shape of the laser spot can be square, rectangle, round, ellipse, pentagon, hexagon, etc.. Such small laser spot, for instance, is a square laser spot with a side length of 3 - 250pm, or a round laser spot with a diameter of 1 - 300µm. In the meantime, the present invention adjusts the energy distribution of each laser laser spot and changes the laser energy distribution condition inside the prior laser spot. The energy inside the large laser spot has an uniform distribution in the prior arts. The energy on the edge of the laser spot changes rapidly which leads to damages easily. The prior energy distribution of the pulse laser spot is illustrated as Figure 3a. In the figure, axis x indicates the direction of the side length of the laser spot, axis y indicates the amount of energy, the zero point of axis x is corresponding to the center of the laser spot. The inventors changed the energy distribution conditions inside the laser spot in the present invention, and didn't seek the uniformity of the energy, and took the gradual change of the energy on the laser spot edge into consideration. The energy distribution of the present invention is illustrated as Figure 3b. In comparison to the large laser spot, the small laser spot can implement the gradual change of the laser energy of the laser spot more easily. Just by addressing the gradual change process (the gradual change from the strong energy area near the center of the laser spot to the weak energy area far away from the center) of the energy of the edge area of the laser spot and improving the stress condition of the GaN-based material on the edge of the laser spot, the small laser spot damage-free laser lift-off is implemented.

The solid-state laser used in the present invention can be an improved solid-state harmonic frequency laser source. The laser energy's spacial distribution inside the laser spot is improved by that the energy is the highest in the center of the laser spot and is gradually reduced toward the periphery. The internal energy throughout the laser spot can be distributed in a Gauss distribution or approximately distributed in a Gauss distribution. It is illustrated as Figure 3b.

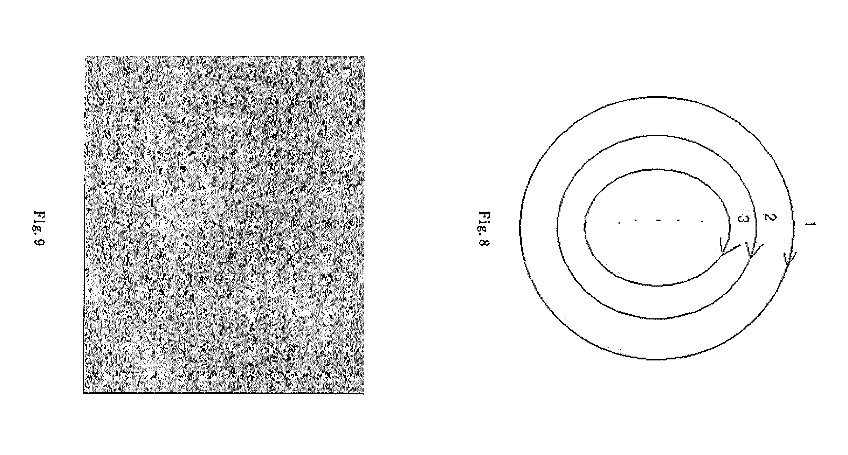

The present invention realizes small laser spot damage-free laser lift-off and achieves a blind scanning lift-off method without unneccessary accurate positioning between the laser spot and the chip ((lift-off surface as shown in Figure 9, without apparent damage).The present invention improves the scanning mode of the laser lift-off and needn't to adjust the area of the laser spot according to the size of the GaN device unit and carry out an accurate positioning of the laser spot in the beginning after the implement of the electroplating or bonding process in the conventional techniques. The present invention can carry out scanning directly without unneccessary middle intermission and instant detection.

The present invention designs a kind of light beam shaping system and changes the spacial distribution of the light beam and makes it helpful to the energy distribution inside the laser spot. It also changes the requirement that the energy distribution is entirely supposed to be a flat roof alike distribution in the prior light path. It is changed into Gauss distribution and the light waist is less than the length of the bottom side. Thus it is helpful to the connection between the laser spots and won't lead to the destruction of the substrate material. The principle of the light path is shown in Figure 2.

The light scanning system uses a laser marking alike scanning system. Such system hasn't been used in lift-off system at the present time yet. The possible reason lies in that this kind of method hasn't come to being products because of the problem which exists during the accurate positioning. But this problem can be solved by our micro area laser lift-off (MALLO) technology. The principle of the light path is shown in Figure 1. Based on the successful solution of blind scanning, the inventors of the present invention advanced some special scanning lift-off solutions according to the problems which exist in the prior lift-off technologies, so as to disperse the continuing heat-rising in the lift-off area caused by the laser pulse. Because the gallium drops and nitrogen bubbles are formed between the film layer and the substrate during the lift-off process, different scanning paths will possess different stress distributions. Therefore, the inventors of the present invention advanced various scanning paths and solved the stress problem during the prior lift-off process of the materials with different structures. In the meantime, the yields are improved.

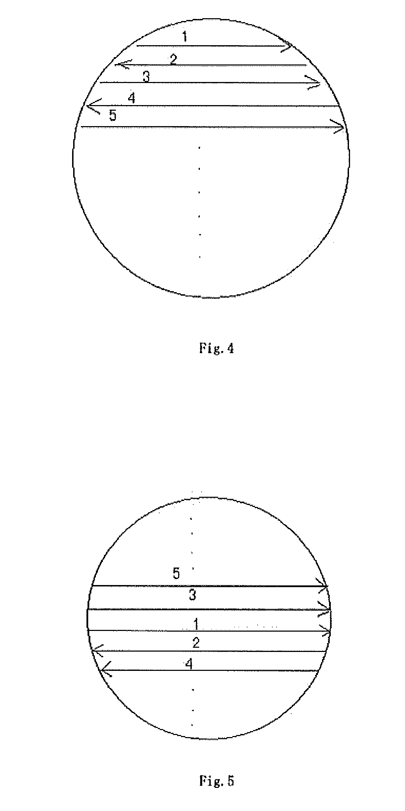

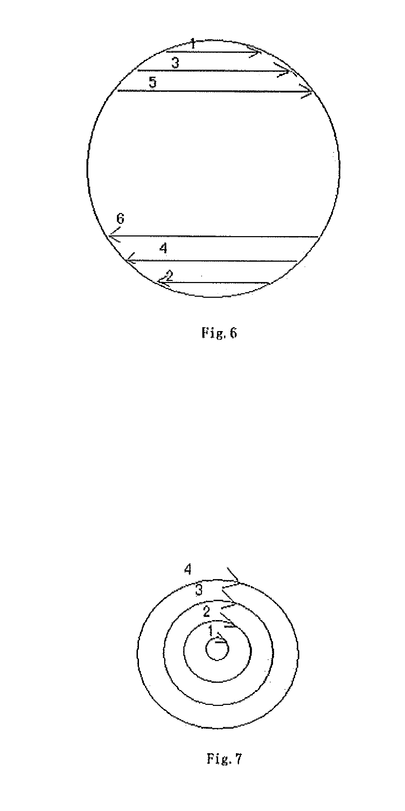

Figure 4 - Figure 8 illustrate several typical scanning paths of the present invention.

The present invention adopts specific scanning paths, for instance, spiral scanning from inside to outside, inner circle scanning from outside to inside, concentric circle scanning from outside to inside, scanning alternatively up and down. The advantage is that it can choose different scanning strategies according to the characteristics of the components and the GaN films.

In comparison with prior arts, the advantageous effects of the present invention are: First, the laser lift-off process is drastically simplified; Second, the operating efficiency of laser lift-off is largely improved; Thirdly, the failure rate is reduced; Fourthly, obstacles to applying laser lift-off in manufacturing are removed, which advances the laser lift-off in manufacturing processes.

## Claims

1. Solid-state laser lift-off apparatus comprising a solid-state laser, a light beam shaping lens, motors of oscillating mirrors, oscillating mirrors and a field lens, as well as a movable platform, an industrial control computer and control software; the said light beam shaping lens is under the laser; the said oscillating mirrors, the motors of oscillating mirrors and the field mirrors, the light beam shaping lens are behind the laser, shaping the laser beam from the said solid-state laser; the said motors of oscillating mirrors are in front of the said field lens, controlling the movement of the said oscillating mirrors according to the instruction of the control software to implement different light beam scanning paths; the said platform is under the said solid-state laser; the said control software runs in the said industrial control computer.

2. The solid-state laser lift-off apparatus of claim 1, **characterized in that** the said light beam shaping lens shapes the laser spot into small laser spot in different geometric shapes.

3. The solid-state laser lift-off apparatus of claim 2, **characterized in that** the said geometric shapes include square, rectangle, round, ellipse, pentagon and hexagon.

4. The solid-state laser lift-off apparatus of claim 2, **characterized in that** the said small laser spot is a square laser spots with a perimeter of 3∼ 1000µm.

5. The solid-state laser lift-off apparatus of claim 2, **characterized in that** the said small laser spot is a round laser spot with a diameter of 3∼300µm.

6. The solid-state laser lift-off apparatus of claim 2, **characterized in that** the energy of the said small laser spot is the highest in the center and is gradually reduced toward the periphery.

7. The solid-state laser lift-off apparatus of claim 1, **characterized in that** the said solid-state laser is a DPSS solid-state laser with a wavelength less than 400nm.

8. The solid-state laser lift-off apparatus of claim 1, **characterized in that** the said light scanning is produced by using the motors of oscillating mirrors to drive the oscillating mirrors.

9. Solid-state laser lift-off method for applying the said solid-state laser lift-off apparatus of claim 1, **characterized by** using small laser spot to scan.

10. The lift-off method of claim 9, **characterized in that** the said small laser spot is a square laser spot with a perimeter of 3∼1000µm.

11. The lift-off method of claim 9, **characterized in that** the said small laser spot is a round laser spot with a diameter of 3∼300µm.

12. The lift-off method of claim 9, **characterized in that** the energy of the said small laser spot is the highest in the center and is gradually reduced toward the periphery.

13. The lift-off method of claim 9, **characterized by** using various different scanning paths.

14. The lift-off method of claim 9, **characterized in that** the said small laser spot scans in any direction for separation without unnecessary accurate positioning with the chip during the scanning.
